Europäisches Patentamt

European Patent Office

Office européen des brevets

(19)

(11) Numéro de publication: **0 072 292**
**A1**

## (12) DEMANDE DE BREVET EUROPEEN

(21) Numéro de dépôt: **82401400.5**

(22) Date de dépôt: **28.07.82**

(51) Int. Cl.³: **G 01 R 15/07**

(30) Priorité: **12.08.81 GB 8124677**

(43) Date de publication de la demande: **16.02.83
Bulletin 83/7**

(84) Etats contractants désignés: **CH DE FR GB IT LI NL SE**

(71) Demandeur: **ENERTEC SOCIETE ANONYME, 12, Place
des Etats Unis, F-92120 Montrouge (FR)**

(72) Inventeur: **Meyrueix, Paul, 11-15, rue Sarrette,
F-75014 Paris (FR)**

(74) Mandataire: **Bentz, Jean-Paul, GIERS
SCHLUMBERGER 12, Place Des Etats Unis,
F-92124 Montrouge Cedex (FR)**

(54) **Procédé de mesure d'un courant électrique et appareil pour sa mise en oeuvre.**

㊋ Un appareil conforme à l'invention permettant de détecter l'intensité d'un courant électrique circulant dans un conducteur (10) comprend une fibre optique (12) enroulée autour du conducteur, un laser (18) disposé de façon à injecter de la lumière à polarisation plane dans la fibre, et un prisme de Wollaston (30) et des photo-détecteurs (32) disposés pour détecter l'angle de rotation subi par le plan de polarisation par l'action de l'effet Faraday du le champ magnétique du courant sur la lumière traversant la fibre.

Pour éviter l'affaiblissement de la rotation Faraday en raison de la biréfringence, la fibre est fortement tordue autour de son propre axe; en outre, une extrémité de la fibre est métallisée (22) pour que la lumière traverse la fibre dans les deux sens avant de pénétrer dans le prisme de Wollaston, ce qui permet d'annuler toute rotation sensible à la température du plan de polarisation dûe à la torsion de la fibre.

## PROCEDE DE MESURE D'UN COURANT ELECTRIQUE
## ET APPAREIL POUR SA MISE EN OEUVRE

La présente invention concerne les procédés et appareils de mesure de courants électriques et a trait notamment à des procédés et appareils destinés à détecter par l'effet Faraday l'intensité d'un courant circulant dans un conducteur.

La mise en place de tensions de travail pour les lignes électriques de l'ordre de plusieurs centaines de kilovolts s'accompagne d'un problème important concernant la surveillance et le contrôle de ces lignes. D'une part, la vitesse de fonctionnement élevée nécessaire, par exemple, aux systèmes de protection pour éviter des dommages importants en cas de panne ne peut être assurée qu'à l'aide d'un matériel électronique. D'autre part, ce matériel ne convient qu'à une exploitation à tension relativement faible et doit être isolé électriquement par conséquent avant d'être utilisé avec des lignes haute tension. Bien que l'on puisse utiliser des transformateurs classiques à cette fin, ils sont très coûteux et peu commodes.

La possibilité d'utiliser l'effet Faraday pour faciliter la mesure des courants dans ces conditions a fait l'objet de nombreuses études depuis des années. Cette technique se base sur le fait que lorsqu'un faisceau de lumière à polarisation plane est exposé à un champ magnétique, le plan de polarisation tourne d'un angle proportionnel à l'intensité du champ (effet Faraday). Si le trajet parcouru par la lumière est une boucle fermée autour d'un conducteur dans lequel circule un courant électrique, la rotation du plan de polarisation est proportionnelle à l'intensité du courant et aux nombre de spires de la boucle autour du conducteur.

Les premières propositions de mise en oeuvre de cette technique font intervenir un faisceau projeté par un laser à polarisation plane, situé sur le sol au-dessus d'une ligne électrique, vers un ensemble de blocs de verre monté sur la ligne. Les blocs sont disposés de chaque côté de la ligne et agencés de façon à renvoyer le faisceau laser vers un détecteur/analyseur optique situé au sol. Ce détecteur/analyseur reçoit le faisceau et mesure l'angle de rotation du plan de polarisation de la lumière à l'intérieur des blocs, d'où on peut déduire l'intensité du courant. En pratique, cette approche connaît de graves problèmes dûs à des vibrations et aux mouvements provoqués par le vent ou à une interaction électromagnétique entre des conducteurs voisins.

Grâce à la production commerciale de fibres optiques, il y a un nouvel intérêt à cette utilisation de l'effet Faraday, en enroulant par exemple la fibre une ou plusieurs fois autour du conducteur et en amenant les extrémités de la fibre à la source lumineuse et au détecteur respectivement. Toutefois, les fibres optiques présentent en pratique une biréfringence linéaire intrinsèque importante, à laquelle s'ajoute ultérieurement la biréfringence linéaire due à des facteurs extrinsèques tels que la courbure et la tension axiale de la fibre. Cette biréfringence réduit la modification de polarisation due à l'effet Faraday. On a proposé (S.C. Rashleigh & R. Ulrich, Appl. Phys. Lett. 34 (11), le 1er Juin 1979) de résoudre le problème de biréfringence en tordant la fibre le long de son propre axe. Toutefois, cette solution introduit, à son tour, une grande sensibilité à des variations de température - les auteurs cités proposent de surmonter cet inconvénient en réalisant la bobine de fibre en deux sections, enroulées l'une immédiatement après l'autre mais tordues en sens opposée. Or, ce remède s'avère non seulement difficile et complexe à mettre en oeuvre, mais nécessite en outre exactement le même nombre de torsions de la fibre autour de son axe pour les deux sections.

Selon un aspect, la présente invention a pour objet un procédé de détection de l'intensité d'un courant circulant dans un conducteur par détection de l'angle de rotation, dû à l'effet Faraday, du plan de polarisation d'un faisceau de rayonnement électromagnétique polarisé linéairement qui a parcouru un trajet autour du conducteur, caractérisé en ce qu'il consiste à faire parcourir un faisceau de rayonnement le même trajet dans les deux sens dans une fibre optique qui est tordue autour de son propre axe de façon connue.

Selon un autre aspect, la présente invention a pour objet un procédé de détection, par l'effet Faraday, de l'intensité d'un courant circulant dans un conducteur à l'aide d'une fibre optique formant boucle dont au moins une spire est disposée autour du conducteur, un rayonnement électromagnétique polarisé linéairement étant injecté dans une extrémité de la fibre optique, et la direction du plan de polarisation du rayonnement étant analysée après son parcours dans la fibre, ce qui permet de détecter l'intensité du courant en fonction de l'angle de rotation subi par le plan de polarisation sous l'effet du champ magnétique du courant, caractérisé en ce que :

- la fibre est tordue autour de son propre axe de façon connue afin de réduire l'effet de la biréfringérence;

- le rayonnement est injecté dans la même extrémité de la fibre optique d'où il sort à des fins d'analyse, le rayonnement étant couplé dans la fibre optique par l'intermédiaire de moyens de couplage directionnel; et

- le rayonnement arrivant à l'autre extrémité de la fibre est renvoyé dans celle-ci par des moyens de réflexions disposés à cette extrémité de la fibre;

- le rayonnement parcourant de ce fait la fibre dans les deux sens avant l'analyse de son sens de polarisation afin de réduire la sensibilité à la température.

Selon un autre aspect, la présente invention a pour objet un appareil de détection de l'intensité d'un courant circulant dans un conducteur en détectant l'angle de rotation, rotation due à l'effet Faraday, du plan de polarisation d'un faisceau de rayonnement électromagnétique polarisé linéairement qui a parcouru un trajet autour du conducteur, caractérisé en ce que le faisceau de rayonnement parcourt le même trajet dans les deux sens, dans une fibre optique qui est tordue autour de son propre axe de manière connue.

Selon un autre aspect, la présente invention a pour objet un appareil de détection, par l'effet Faraday, de l'intensité d'un courant circulant dans un conducteur, comprenant une fibre optique formant boucle dont au moins une spire est disposée autour du conducteur, une source de rayonnement électromagnétique polarisé linéairement disposée de façon à injecter ledit rayonnement dans une extrémité de la fibre optique, et des moyens disposés de façon à détecter le rayonnement et d'analyser le sens du plan de polarisation de celui-ci après qu'il ait parcouru la fibre, afin de détecter l'intensité du courant en fonction de l'angle de rotation subi par le plan de polarisation sous l'effet du champ magnétique du courant, caractérisé en ce que :

- la fibre est tordue autour de son propre axe de manière connue afin de réduire l'effet de la biréfringence;

- la source de rayonnement et les moyens de détection de rayonnement sont disposés à la même extrémité de la fibre optique et sont couplés à celle-ci par l'intermédiaire de moyens de couplage directionnel; et

- des moyens de réflexion sont disposés à l'autre extrémité de la fibre pour renvoyer dans la fibre le rayonnement arrivant à cette extrémité;

- ledit rayonnement parcourant la fibre dans les deux sens avant d'entrer dans les moyens de détection, afin de réduire la sensibilité à la température.

Grâce à la présente invention, on conserve l'activité optique (biréfringence circulaire) introduite par torsions de la fibre elle-même, palliant ainsi aux effets perturbateurs de la biréfringence (linéaire) résultant de la nature de la fibre elle-même et, d'une façon plus importante, de son enroulement autour du conducteur. Or, la rotation sensible à la température du plan de polarisation du rayonnement due à la biréfringence circulaire (laquelle rotation s'ajoute à la rotation à effet Faraday), est un effet réciproque et s'annule de ce fait exactement par suite de son parcours dans les deux sens dans la fibre. Par contre, l'effet Faraday non réciproque n'est pas annulé : la grandeur de cette rotation se voit en effet doublée.

Une forme d'exécution de la présente invention est décrite ci-après à titre s'exemple, en référence aux dessins annexés dans lesquels :

- la figure 1 est un schéma représentant l'agencement de l'appareil;

- la figure 2 est une coupe transversale d'un support de fibre optique dans l'appareil à l'état non dilaté;

- la figure 3 est une vue en coupe transversale d'un support à l'état dilaté;

- la figure 4 est une vue en coupe longitudinale du support; et

- la figure 5 montre un appareil permettant simultanément la torsion de la fibre optique et son enroulement sur le support.

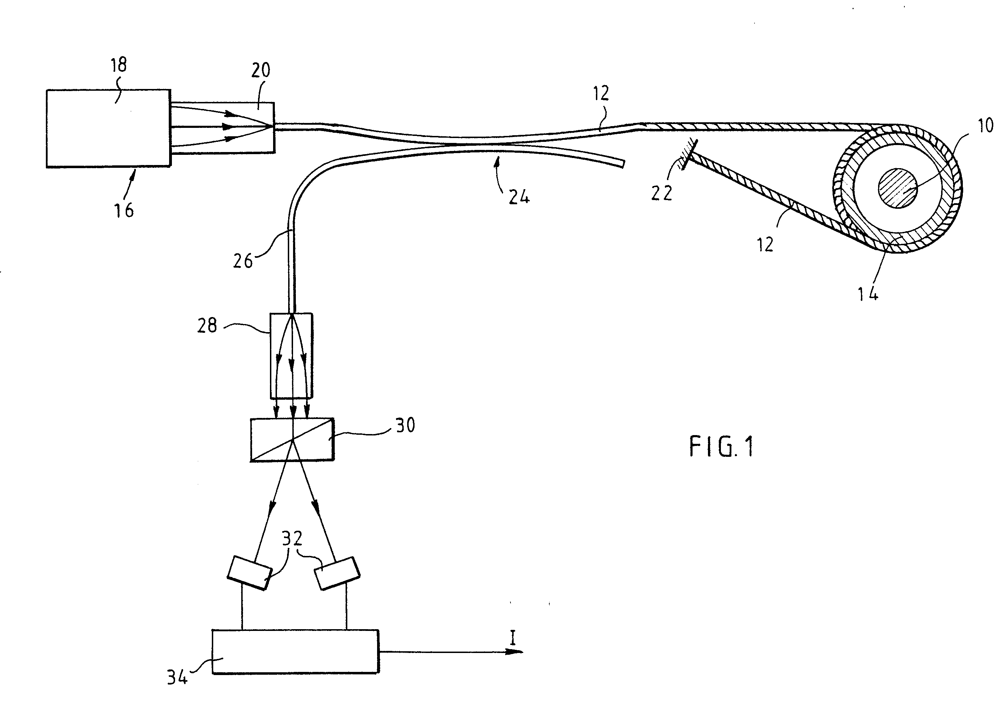

Sur la figure 1, on voit un appareil destiné à mesurer l'intensité d'un courant circulant dans un conducteur 10 (par exemple une ligne électrique fonctionnant sous une tension typique de plusieurs centaines de kilovolts), cet appareil comprenant une fibre optique 12, choisie pour présenter une biréfringence intrinsèque la plus faible possible, sous forme de boucle dont au moins une spire entière est disposée autour du conducteur 10. S'il y a plus d'une spire, il faut prévoir un support spécial 14 destiné à porter la fibre 12. Une extrémité de la fibre 12 est raccordée à une source 16 de rayonnement électromagnétique comprenant un laser hélium-néon 18 et un objectif 20 en barreau à gradient d'indice d'un quart de pas (quarter-pitch). A son autre extrémité, la fibre 12 se termine en une surface plane qui est normale à l'axe de la fibre 12 et qui est métallisée (comme cela est indiqué en 22), de sorte que la lumière arrivant à cette extrémité après avoir parcouru la fibre 12 est renvoyée dans la fibre dans le sens inverse. La fibre 12 peut être constituée par une fibre monomode ou par une fibre multimode, mais dans ce dernier cas, la source de rayonnement 12 doit être agencée pour n'exciter que le mode fondamental de la fibre 12.

Entre la source de rayonnement 16 et la section enroulée autour du conducteur 10, la fibre est agencée pour faire partie d'un coupleur directionnel 24. Le but du coupleur 24 est de permettre à la lumière revenant dans la fibre 12 vers la source 16 (c'est-à-dire après être renvoyée par la métallisation 22) d'être extraite et séparée de la lumière partant de la source 16, avant l'analyse de sa polarisation. La lumière ainsi extraite est dirigée par un second tronçon de fibre 26 (faisant partie du coupleur 24 comme on le décrit ci-après) et un second objectif en barreau à gradient d'indice d'un quart de pas 28 sur un prisme dit de Wollaston 30 qui permet de séparer un faisceau lumineux en composantes présentant des sens de polarisation orthogonaux. Ces deux composantes, faisant un certain angle entre elles à la sortie du prisme de Wollaston, sont détectées par des photo-récepteurs respectifs 32 (par exemple, des photo-diodes semi-conductrices), qui fournissent à un circuit de traitement de signaux 34 des signaux indicatifs de l'intensité de chaque composante. Ce circuit (qui peut être réalisé selon des techniques connues en utilisant, par exemple, des composants logiques numériques ou un microprocesseur) est agencé pour déduire l'intensité du courant I circulant dans le conducteur 10 à partir des intensités des composantes $I_1$ et $I_2$ séparées par le prisme de Wollaston, selon la formule suivante :

$$I = ( 4NV . \sin[(I1-I2)/(I1+I2)] )^{-1} \qquad (1)$$

où N représente le nombre de spires de la fibre optique 12 autour du conducteur 10; et

V représente la constante de Verdet pour la fibre optique particulière 12 et la longueur d'onde du rayonnement utilisé.

Le coupleur directionnel 24 est réalisé, de manière connue, à partir de la fibre 12 et à partir d'un second tronçon de fibre 26 en juxtaposant les fibres 24 et 26 de façon que leurs coeurs constituent en réalité un seul canal optique intégral. On choisit l'écart entre les fibres et la longueur de la région de contact pour que la lumière entrant dans le coupleur par une des fibres sorte du coupleur approximativement uniformément divisée entre les fibres.

On préfère un coupleur directionnel à la place d'un miroir semi-étamé, parce que la métallisation d'un tel miroir perturbe fortement la polarisation de la lumière qu'elle réfléchit, rendant de ce fait plus compliquée la détection du changement de polarisation de cette lumière. Les deux types de coupleurs diminuent de moitié l'intensité du faisceau lumineux désiré à chaque rencontre avec le coupleur, ce qui a pour conséquence, pour l'analyse de la polarisation, un faisceau de sortie d'une intensité un quart de celle du faisceau d'entrée initiale provenant de la source lumineuse 16, si bien que le miroir semi-étamé ne présenterait aucun avantage de ce point de vue.

L'utilisation d'un objectif en barreau à gradient d'indice d'un quart de pas 20 apporte des avantages en permettant une simplification du montage et de l'interconnexion du laser 18, de l'objectif 20 et de la fibre optique 12. Une caractéristique de l'objectif 20, dûe à la variation de l'indice de réfraction qui se produit à travers lui, est que la lumière provenant du laser 18 et entrant dans l'objectif se trouve toujours focalisée au même point sur sa surface de droite (selon la figure 1) indépendamment du mouvement du laser 18 dans un sens transversal par rapport à l'axe de l'objectif 20. Ainsi, on peut tout simplement fixer la fibre optique 12 en permanence sur ce point de l'objectif 20, supprimant de ce fait le risque d'un mouvement relatif entre l'objectif 20 et la fibre 12, risque qui existe lorsqu'on utilise un objectif classique. En outre, à condition que l'objectif 20 et le laser 18 soient supportés de manière adéquate vis-à-vis des forces de flexion tendant à changer l'angle entre leurs axes, la fibre optique 12 sera toujours correctement éclairée malgré des vibrations en translation entre le laser 18 et l'objectif 20.

Il est bien connu que la superposition d'un niveau important de biréfringence linéaire à une activité optique relativement faible (dans ce cas, l'effet Faraday) a pour résultat une diminution sensible de cette activité optique. On a proposé, comme on l'a déjà signalé, pour surmonter ce problème, de tordre fortement la fibre 12 autour de son propre axe - ce qui est indiqué schématiquement sur la figure 1 pour les traits obliques de la fibre 12. Une telle torsion introduit deux phénomènes supplémentaires :

- une rotation des axes optiques de la fibre elle-même en fonction de la torsion, dans le système de coordonnées de l'appareil global; et

- une activité optique d'origine élasto-optique (biréfringence circulaire).

Ces deux phénomènes tendent à neutraliser l'effet nocif de la biréfringence linéaire intrinsèque; la biréfringence linéaire extrinsèque, et notamment la biréfringence induite par flexion de la fibre, est neutralisée par l'activité optique seule.

Le nombre de tours par unité de longueur de la fibre est choisi en fonction de la valeur de la biréfringence intrinsèque de la fibre et du rayon de courbure de la fibre autour du support 14. Plus la biréfringence intrinsèque est importante et/ou plus le rayon de courbure est faible, plus la torsion par unité de longueur doit être importante. Il est souhaitable d'utiliser une fibre possédant une biréfringence intrinsèque aussi faible que possible, et d'enrouler la fibre sur un support 14 de rayon suffissament grand pour que le degré de torsion ne dépasse pas la résistance à la torsion de la fibre ni provoque un fluage progressif du matériau de la fibre.

Toutefois, l'activité optique induite par torsion de la fibre est sensible à la température, et la direction du plan de polarisation de la lumière sortant de la fibre est également fonction de la température. Par conséquent, en pratique, la déduction de l'intensité du courant circulant dans le conducteur 10 à partir de l'angle de rotation de la lumière à polarisation plane traversant la fibre 12 d'une extrémité à l'autre serait fortement perturbée par des variations de température.

Selon la présente invention, ce problème est résolu en faisant en sorte que la lumière traverse la fibre tordue 12 dans les deux sens, c'est-à-dire du coupleur directionnel 24 vers la métallisation 22 et retour. Le renvoi de la lumière sur le même trajet a pour résultat, quelle que soit la température, l'annulation exacte de la rotation (réciproque) sensible à la température du plan de la polarisation provoquée par la torsion de la fibre 12. La raison en est que la rotation se fait dans le même sens (dans le système de coordonnées du faisceau lumineux) pour l'un et l'autre sens de propagation dans la fibre, si bien que la rotation totale (dans le système de coordonnées de l'appareils global) pour le parcours entier dans les deux sens est nulle.

Par contre, la direction apparente du champ magnétique du courant (dans le système de coordonnées du faisceau lumineux) se trouve inversée lorsque le faisceau lumineux est renvoyé par la métallisation 22. Du fait que la direction du champ magnétique détermine la direction de la rotation Faraday, cette direction de rotation, par rapport au faisceau lumineux, se trouve également inversée. Toutefois, dans le système de coordonnées de l'appareil global, la direction de rotation reste inchangée lorsque la direction du faisceau lumineux est inversée au niveau de la métallisation 22. Ainsi, les rotations Faraday (non réciproques) provoquées pour chaque sens de propagation dans la fibre tordure 12 viendront s'ajouter, augmentant de ce fait l'angle de rotation pour une intensité déterminée du courant et facilitant la mesure du courant selon une résolution déterminée.

Bien que l'on puisse obtenir le même effet en tordant une moitié de la fibre 12 dans un sens et l'autre moitié dans le sens contraire, comme on l'a déjà mentionné, une telle configuration est plus difficile à fabriquer et resterait en outre sensible à des différences de températures entre les sections de la fibre tordue en sens opposés.

En pratique, deux systèmes tels que celui représenté sur la figure 1 serait nécessaire pour un seul détecteur de l'intensité de courant, l'un étant disposé pour détecter les intensités se situant entre 10 et 1000 ampères et l'autre, comportant un moindre nombre de spires de fibres optiques 12 autour du conducteur 10, pour mesurer les intensités supérieurs à 1000 ampères. Un tel agencement serait souhaitable pour faciliter la mesure de toute la gamme d'intensités avec la résolution désirée et sans ambiguité.

Il est évident que la métallisation 22 doit être disposée perpendiculairement à l'axe de la fibre 12 pour que la lumière qui la frappe soit renvoyée sans perte dans la fibre 12. A l'heure actuelle, on obtient ce résultat grâce à un procédé dit "entaillé-étiré" pour obtenir une surface d'extrémité naturellement abrupte et lisse.

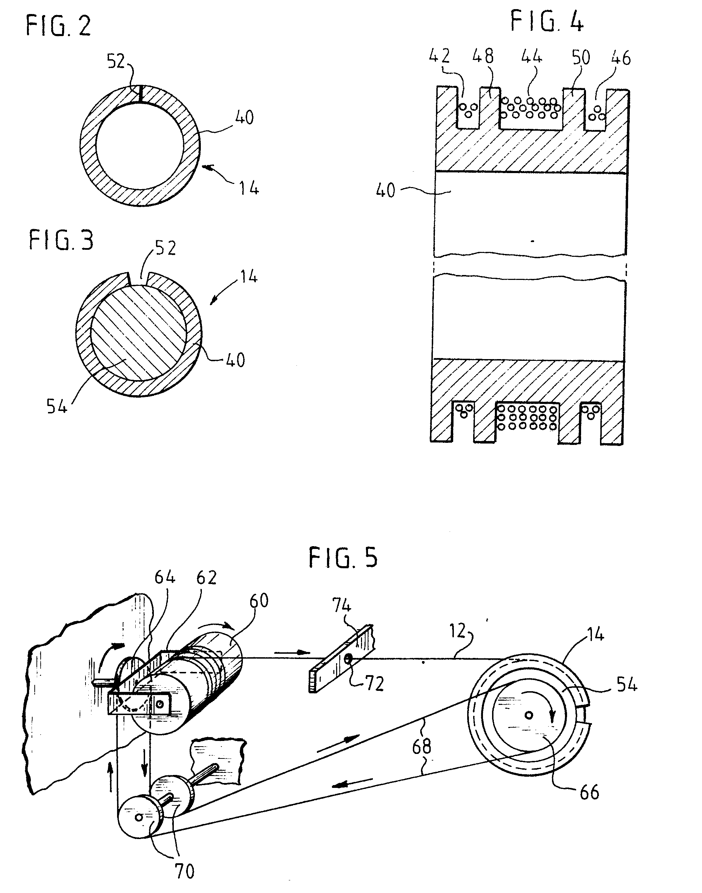

Le matériau et la réalisation du support 14 de la fibre 12 doivent être choisis pour éviter une tension sur la fibre 12 dûe à des dilatations et contractions provoquées par les variations de température et les différences de coefficients de dilatation de la fibre 12 et du support 14. Outre le risque d'une cassure de la fibre 12, une telle tension pourrait imprimer une biréfringence supplémentaire et des effets associés nocifs à l'effet Faraday recherché. Une forme du support 14 qui satisfait à cette condition en permettant à la fibre tordue de reposer sur lui sans serrer est représentée sur les figures 2, 3, et 4.

En se référant aux figures 2 et 4, le support 14 comprend un anneau 40 en une matière plastique de faible coefficient de dilatation, de bonnes propriétés d'isolation électrique et d'une élasticité modérée. L'anneau 40 comporte trois rainures 42, 44 et 46 réparties axialement sur lui, comme le montre la figure 4, la rainure centrale 44 étant plus large que les deux autres. Le diamètre du fond de chaque rainure est légèrement inférieur au diamètre de la bobine de fibre optique 12 devant être réalisée sur le support 14. Un canal (non représenté) traverse, sous un angle oblique chaque paroi 48 et 50 séparant les paires de rainures voisines 42/44 et 44/46 pour permettre à la fibre optique de passer d'une rainure à la rainure suivante. L'anneau 40 est coupé dans le sens radial en un point 52 autour de sa circonférence (voir la figure 2).

Avant d'enrouler la fibre optique 12 sur le support 14, on élargit légèrement le support 14 en écartant les faces de la coupure 52 l'une de l'autre et en le plaçant sur un mandrin 54 d'un diamètre légèrement supérieur au diamètre intérieur de l'anneau 40 - voir figure 3. L'élasticité du matériau de l'anneau 40 est choisie de manière appropriée pour le permettre. Une fois la fibre enroulée sur l'anneau 40, comme on l'a décrit ci-dessous, on retire l'anneau 40 du mandrin 54, ce qui permet à l'anneau 40 de reprendre son diamètre initial plus faible et on peut coller les faces de la coupure 52 ou les fixer l'une à l'autre de façon permanente de toute autre manière appropriée.

Il en résulte que le diamètre des spires de la fibre optique 12 sur le support 14 est légèrement supérieur au diamètre du support 14, ce qui permet aux fibres 12 de reposer sur le support 14 sans le serrer et se trouve à l'abri de la dilatation ou de la contraction thermique ou des vibrations mécaniques du support 14. Cela est représenté sur la fiture 4, dont la moitié inférieure représente la position de la fibre 12 à l'état dilaté du support 14 tandis que la moitié supérieure représente la position de la fibre 12 une fois que le support 14 a repris son état non dilaté. En outre, en supposant que la fibre 12 a une section transversale uniforme, la torsion de la fibre 12 se répartira naturellement et uniformément sur toute la longueur de la fibre libre entre les points où elle est fixée sur le support 14 au commencement et à la fin de la bobine de fibre. Ainsi, il n'est plus nécessaire de fixer la fibre 12 sur le support 14 à des intervalles réguliers (à chaque spire, par exemple) pour assurer une répartition uniforme de la torsion.

Sur la figure 5, on a représenté un appareil permettant d'enrouler la fibre optique 12 sur le support 14 tout en communiquant, en même temps, à la fibre 12, le degré de torsion désiré par unité de longueur.

Sur la figure 5, l'appareil comprend une bobine 60 (dont la dimension n'est pas critique) qui porte la longueur nécessaire de fibre optique (déjà métallisée à une extrémité) et qui est montée à rotation entre les bras d'un étrier 62. Cet étrier 62 est fixé sur une poulie 64 montée de façon à pouvoir tourner autour d'un axe horizontal perpendiculaire à l'axe de la bobine 60. Le support 14 est porté, comme on l'a déjà signalé, par le mandrin 54 sur lequel est fixée une autre poulie 66 pouvant tourner autour d'un axe horizontal perpendiculaire à l'axe de la poulie 64. Un fil d'entraînement tendu 68 passe autour de chaque poulie 64 et 66, en étant guidé sur deux poulies de renvoi 70 dont les axes sont parallèles à l'axe de la poulie 66.

Pour enrouler la fibre sur le support 14, on passe d'abord l'extrémité non métallisée de la fibre 12 dans un trou de guidage 72 prévu dans un bras 74 et on la fixe sur le suppport 14 dans une rainure latérale 42 ou 46 (voir la figure 4). On fait tourner ensuite la poulie 66, soit manuellement, soit à l'aide d'un moteur (non représenté), pour enrouler une portion initiale de la fibre dans la rainure latérale. Par la suite, on va éventuellement dérouler cette première portion pour raccorder la bobine de fibre optique au coupleur directionnel 24 (voir la figure 1) et sa longueur est choisie en conséquence.

On passe ensuite la fibre dans le canal reliant la rainure latérale et la rainure centrale 44 et, après l'avoir fixée à celle-ci, on enroule la longueur désirée de fibre dans la rainure centrale 44 pour réaliser la bobine de fibre optique proprement dite. On fixe ensuite la fibre sur la rainure centrale 44, on la passe dans le canal qui communique avec l'autre rainure latérale et on enroule le reste de la fibre dans cette rainure latérale et l'extrémité libre (métallisée) est fixée provisoirement en position. On peut ensuite dérouler la portion dans cette rainure latérale et la disposer à côté du tronçon de fibre s'étendant jusqu'au coupleur directionnel 24 afin de fermer correctement la boucle formée par la fibre 12 autour du conducteur 10 (voir la figure 1).

On voit sur la figure 5 que, à mesure que la poulie 66 tourne pour enrouler la fibre sur le support 14, le fil d'entraînement 68 fera tourner simultanément la poulie 64 et l'étrier 62, entraînant ainsi en rotation l'axe de la bobine 60 et tordant la fibre 12 autour de son propre axe. Le degré de torsion de la fibre 12 par unité de longueur sera fonction du diamètre du support (à l'état dilaté) 14 et du rapport des diamètres des poulies 64 et 66.

A titre d'exemple, on envisage que, en utilisant une fibre optique de 100 microns (micromètres) de diamètre et d'une biréfringence intrinsèque de 0,4 radian/mètre et une bobine de fibre optique typique d'un diamètre de 16 cm, la torsion de la fibre autour de son propre axe serait de 10 tours par mètre de longueur. Le nombre de spires de la fibre sur le support 14 sera fonction de l'intensité du courant à mesurer, se situant entre plusieurs dizaines de spires pour les intensités de quelques dizaines ou centaines d'ampères jusqu'à une spire pour les intensités très élevées.

## REVENDICATIONS

1. Procédé de détection de l'intensité d'un courant circulant dans un conducteur par détection de l'angle de rotation dû à l'effet Faraday du plan de polarisation d'un faisceau de rayonnement électromagnétique polarisé linéairement qui a parcouru un trajet autour du conducteur, caractérisé en ce qu'il consiste à faire parcourir par le faisceau de rayonnement le même trajet dans les deux sens dans une fibre optique qui est tordue autour de son propre axe de manière connue en soi.

2. Procédé de détection de l'intensité d'un courant circulant dans un conducteur par l'effet Faraday en utilisant une fibre optique formée en boucle dont au moins une spire entoure le conducteur, un rayonnement électromagnétique polarisé linéairement étant injecté dans une extrémité de la fibre optique et la direction du plan de polarisation du rayonnement étant analysée après qu'il ait traversé la fibre, l'intensité du courant étant déduite en fonction de l'angle de rotation subi par le plan de polarisation sous l'effet du champ magnétique du courant, caractérisé en ce que :

- la fibre est tordue autour de son propre axe de manière connue en soi pour réduire l'effet de biréfringence;

- le rayonnement est injecté dans la même extrémité de la fibre optique d'où il sort en vue de l'analyse et il y est couplé à l'aide de moyens de couplage directionnel, et

- le rayonnement arrivant à l'autre extrémité de la fibre est renvoyé dans celle-ci par des moyens de réflexion disposés à cette extrémité de la fibre;

- ledit rayonnement traversant la fibre dans les deux sens avant que sa direction de polarisation soit analysée, afin de réduire la sensibilité à la température.

3. Appareil de détection de l'intensité d'un courant circulant dans un conducteur par détection de l'angle de rotation dû à l'effet Faraday du plan de polarisation d'un faisceau de rayonnement électromagnétique polarisé linéairement qui a parcouru un trajet autour du conducteur, caractérisé en ce qu'il oblige le faisceau de rayonnement à parcourir le même trajet dans les deux sens dans une fibre optique qui est tordue autour de son propre axe de manière connue en soi.

4. Appareil de détection de l'intensité d'un courant circulant dans un conducteur par l'effet Faraday, comprenant une fibre optique formant une boucle dont au moins une spire entoure le conducteur, une source de rayonnement électromagnétique polarisée linéairement disposée de façon à injecter le rayonnement dans une extrémité de la fibre optique et des moyens disposés pour détecter le rayonnement et analyser la direction du plan de polarisation de celui-ci après qu'il ait traversé la fibre, afin de pouvoir déduire l'intensité du courant en fonction de l'angle de rotation subi par le plan de polarisation sous l'effet du champ magnétique du courant caractérisé en ce que :

- la fibre est tordue autour de son propre axe de manière connue en soi pour réduire l'effet de la biréfringence;

- la source de rayonnement et les moyens de détection de rayonnement sont disposés à la même extrémité de la fibre optique et y sont couplés par des moyens de couplage directionnel; et

- des moyens de réflexions disposés à l'autre extrémité de la fibre pour renvoyer dans la fibre le rayonnement arrivant à cette extrémité;

- le rayonnement traversant la fibre dans les deux sens avant d'être introduit dans les moyens de détection, pour réduire la sensibilité à la température.

FIG.1

FIG. 2

FIG. 4

FIG. 3

FIG. 5

# 0072292

**Office européen
des brevets**

**RAPPORT DE RECHERCHE EUROPEENNE**

EP  82 40 1400

| | DOCUMENTS CONSIDERES COMME PERTINENTS | | |
|---|---|---|---|
| Catégorie | Citation du document avec indication, en cas de besoin, des parties pertinentes | Revendication concernée | CLASSEMENT DE LA DEMANDE (Int. Cl. 3) |
| | --- | | G 01 R  15/07 |
| X | DE-A-2 924 804  (LICENTIA) *En entier* | 1-4 | |
| | --- | | |
| X | DE-A-2 855 337  (LICENTIA) *Pages  1,2;  page  7 à partir du alinéa 3,  jusqu'à  la fin de la page  10; figures 4a,4b* & BE - A - 880 755 | 1-4 | |
| | ----- | | |
| | | | DOMAINES TECHNIQUES RECHERCHES (Int. Cl. 3) |
| | | | G 01 R  15/07 |
| Le présent rapport de recherche a été établi pour toutes les revendications | | | |

| Lieu de la recherche | Date d'achèvement de la recherche | Examinateur |
|---|---|---|
| LA HAYE | 03-11-1982 | KUSCHBERT D.E. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503. 03.82